# EUROPEAN PATENT APPLICATION

(11) **EP 4 734 320 A1**
(43) Date of publication of application: **29.04.2026**
(21) Application number: 25210980.6
(22) Date of filing: 24.10.2025
(51) Int. Cl.: H02J 4/00, G01R 31/26, H02H 5/00

(54) **POWER DISTRIBUTION DEVICE WITH SOLID STATE POWER CONTROLLER**

(30) Priority: 25.10.2024 IN 202411081355
(71) Applicant: Eaton Intelligent Power Limited, Dublin 4, D04 Y0C2 (IE)
(72) Inventor: GANDHAM, Lakshmi Satya Sai Nagendra Vivek, Dublin, 4 (IE); ROWLAND, Doyle A., Dublin, 4 (IE); KULKARNI, Sanjay, Dublin, 4 (IE); BHALWANKAR, Chaitanya, Dublin, 4 (IE)
(74) Representative: Collingwood-Pierce, Alexandra Isobel Seymour

(57) **Abstract**

According to some aspects of the present disclosure, a power distribution device comprises one or more input terminals, each being connectable to a respective electrical power supply; one or more output terminals, each being connectable to one or more electric devices; and one or more electrical paths, each connecting a respective one of the one or more input terminals and a respective one of the one or more output terminals and comprising one or more solid-state fuses. According to another aspect of the present disclosure, an aircraft comprises an electric power source; an electrical propulsion system; and the power distribution system described above connected to deliver electrical power from the electrical power supply to the electrical propulsion system.

## Description

### CROSS-REFERENCE TO RELATED APPLICATION

This application claims the benefit of priority to Indian Provisional Application No. 202411081355, filed October 25, 2024, the disclosure of which is incorporated by reference herein its entirety.

### BACKGROUND

Electrical Vertical Take-Off & Landing (eVTOL) vehicle market demands for high power density electrical propulsion and distribution unit (PDU). Each eVTOL vehicle may contain multiple motors, and voltage inverters and converters and needs a power distribution and management system. The power requirements for eVTOL motor loads are much higher than the conventional electrical loads. Chances of instantaneous fault occurrence with high voltage greater than 1000V and high current become more prominent than lower voltage and current (conventional aircraft system). Complex power electronics present in the system causes power quality issues and also variations in currents causing different faults. The conventional PDUs are usually made up of mechanical devices such as bus bars, contactors and wire harness. They are heavy and bulky, difficult to maintain and pose serious problems for complex and multi-input output systems. The reliability is also relatively poor and the fuses may or may not open at exact point. This imposes very serious problems for the eVTOL as many times this requirement is catastrophic. The wire harness is another major issue as it needs to be routed over the bus bars and other elements which are high-voltage. That means the wire harness needs very high insulation. Furthermore, at higher altitude the insulation degrades and still further, the insulation needs to function properly at high temperatures. As well it needs to have fire protection. The total result is that the traditional PDUs and wire harness are bulky, heavy, and expensive.

Efforts are thus ongoing to develop electrical power distribution systems that with meet or exceed the safety standards (such as mean time between failures (MTBF), frequency of failures (e.g., one failure in trillion or less), and sufficiently low electromagnetic interference (EMI) and electromagnetic compatibility (EMC) for eVTOL, while increasing the efficiency and reduce the complexity and cost of eVTOL.

### SUMMARY

In certain embodiments disclosed herein, a power distribution device comprises one or more input terminals, each being connectable to a respective electrical power supply; one or more output terminals, each being connectable to one or more electric devices; and one or more electrical paths, each connecting a respective one of the one or more input terminals and a respective one of the one or more output terminals and comprising one or more solid-state fuses. According to another aspect of the present disclosure, an aircraft comprises an electric power source; an electrical propulsion system; and the power distribution system described above connected to deliver electrical power from the electrical power supply to the electrical propulsion system. The power distribution device or aircraft can further include built-in-testing (BIT) circuits adapted to monitor an operating condition of the one or more solid-state fuses and generate an output signal indicative of the operating condition; and a controller having an input adapted to receive the output signal from the one or more BIT circuits and being adapted to set a state of current flow in the conductive path based on the signal received from the one or more BIT circuits. Both the solid-state fuses and BIT circuits can be redundant fuses and BIT circuits, respectively, in some embodiments.

### BRIEF DESCRIPTION OF THE DRAWINGS

Figure 1 schematically shows an electrical power distribution system (EPDS) for an eVTOL vehicle employing solid-state fuses and associated safety and control systems (not illustrated), in some embodiments.
Figure 2 schematically shows a solid-state fuse circuit that can be used in an EPDS show in Figure 1, in some embodiments.
Figure 3 schematically shows a fuse system that can be used in an EPDS show in Figure 1, in some embodiments.
Figure 4 schematically shows a solid-state fuse assembly that can be used in the fuse system shown in Figure 3, in some embodiments.
Figure 5 schematically shows another solid-state fuse assembly that can be used in the fuse system shown in Figure 3, in some embodiments.
Figure 6 schematically shows an implementation of the fuse system shown in Figure 3, in some embodiments.
Figure 7A schematically shows the lefthand half of another implementation of the fuse system shown in Figure 3, in some embodiments.
Figure 7B is a closer view of a portion, labeled "7B" of the schematic shown in Figure 7A.
Figure 7C is a closer view of a portion, labeled "7C" of the schematic shown in Figure 7A.
Figure 7D is a closer view of a portion, labeled "7D" of the schematic shown in Figure 7A.
Figure 7E is a closer view of a portion, labeled "7E" of the schematic shown in Figure 7D.
Figure 8 schematically shows a solid-state fuse assembly, together with the BIT circuits for monitoring the health of the fuse assembly, and controller for setting the current to the load, in some embodiments.
Figure 9 schematically shows a circuit for controlling the time profile for shutting off the current supplied to the load, in some embodiments.
Figure 10 shows an example time profile for shutting off the current supplied to the load, in some embodiments.
Figure 11 schematically shows a power-on BIT (PBIT) circuit for a solid-state fuse assembly used in the fuse system shown in Figure 7A, in some embodiments.
Figure 12 schematically shows a power-on BIT (PBIT) circuit for a forward-biassed diode used in the fuse system shown in Figure 7A, in some embodiments.
Figure 13 schematically shows a power-on BIT (PBIT) circuit for a reverse-biassed diode used in the fuse system shown in Figure 7A, in some embodiments.
Figure 14 schematically shows a power-on BIT (PBIT) circuit for DC-to-DC relay, contactors, and subfeeder fuses used in the fuse system shown in Figure 7A, in some embodiments.
Figure 15 schematically shows a constant BIT (PBIT) circuit for a solid-state fuse assembly used in the fuse system shown in Figure 7A, in some embodiments.
Figure 16 schematically shows a constant BIT (PBIT) circuit for a DC-to-DC relay used in the fuse system shown in Figure 7A, in some embodiments.
Figure 17A and 17B schematically show, respectively, short-circuit (SC) detector for a solid-state fuse assembly, and a current-sense comparator used in the SC detector, in some embodiments.
Figure 18 schematically shows diode failure detection using current sensors, in some embodiments.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

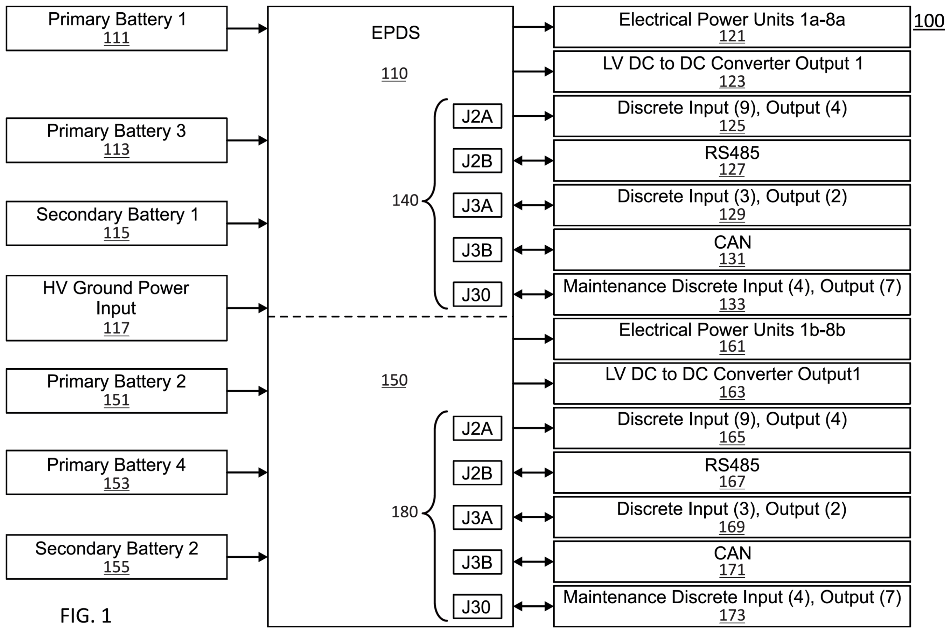

An EPDS 100 according to some embodiments is shown in Figure 1. In this example, the EPDS system is interfaced to an aircraft system as shown and is divided into two halves 110, 150, one for the left half of the aircraft and the other for the right half. The EPDS 100 has four primary battery inputs 111, 151, 113, 153; a high voltage (HV) ground power input 117; and two secondary battery inputs 115, 155. The EPDS 100 further provides output power to sixteen electric power units 121, 161, which can be, for example, motors for the aircraft rotors; two low-voltage (LV) DC-to-DC converter outputs 123, 163, which can be used to power, for example, various electronic devices, include the BIT circuits and controllers for the EPDS itself. The EPDS 100 in this example further includes data communication ports, such as RS485 ports 127, 167, control-area network (CAN) interfaces 131, 171, and discrete inputs and outputs 129, 169. In some cases, maintenance inputs 133, 173 are also provided.

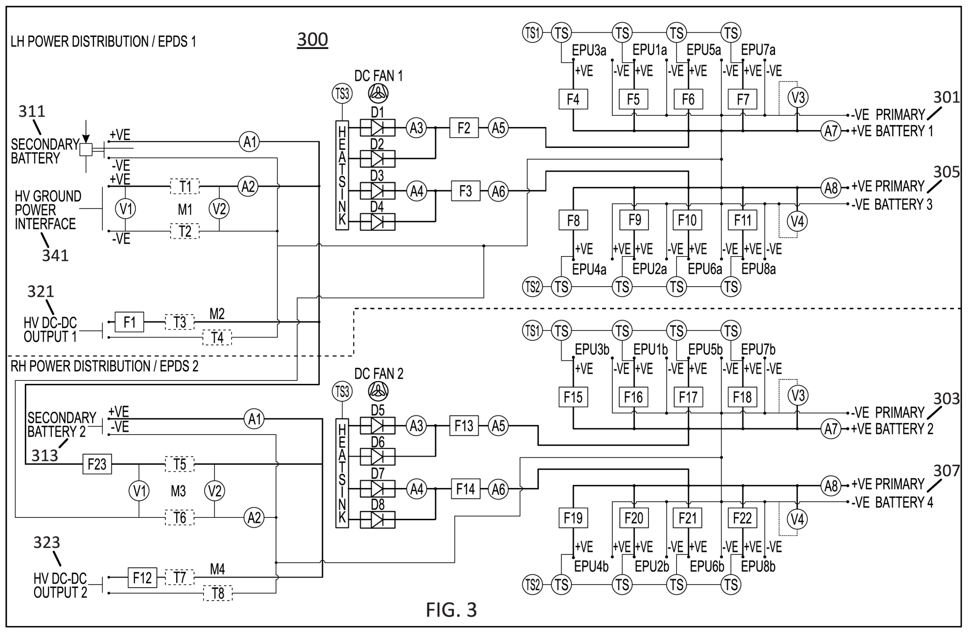

In some embodiments, such the one shown in Figure 3, the EPDS 100 is divided functionally into two halves LH EPDS1 & RH EPDS2. These two interfaces are nearly identical to each other, with minor differences. The main components for LHEPDS1 include (LHEPDS2 includes nearly identical counterparts):
Contactors: There will be two solid-state switches T1, T2 (in a module M1) to enable the HV ground power interface. It is one for positive and one for negative HV line. This is normally switched off; when the HV interlock plugged in signal is received and other safety conditions are met then it will be enabling this contactor. This is used for battery charging and is in EPDS 1 only. Another contactor with solid-state switches T5, T6 (in a module M3) in EPDS2 to connect the power from EPDS1 to EPDS2. This is used for battery charging and in case of emergency power routing. For DC-to-DC power distribution, a relay, with solid-state switches T3, T4 (in a module M2) will be used instead a contactor.

Bus bar: Bus bar will be used to provide high power connections. There will be a network of bus bars from battery inputs to different EPU outputs and DC to DC outputs.

Fuses: Solid-state fuses F1-F11 provide the short circuit protection. One fuse between each Electric power unit (EPU) output and one between main feeder connecting battery to all functions. There is a fuse at DC-to-DC converter output as well.

Diodes: Diodes D1-D4 are used for reverse voltage protection for HV ground power charging interface. It is also used as a blocking device to avoid the current flowing from primary battery to secondary battery. There are two positions in each EPDU for the diodes, the anode will be common, and it is connected to secondary battery and the cathode from each group goes to each primary battery as shown.

Current Sensor: Current sensors A1, A2, ... are used to measure the current and send it over communication interface.

Temperature Sensor: Each EPD Fuse has a temperature sensor TS, TS1, TS2, .... These sensors are resistive type in some examples and can be grouped together to form single resistance. Four EPU Fuse sensors are grouped together. Diode & heatsink assembly also has a dedicated temperature sensor.

Voltage Sensor: Each EPDU four voltage sensors V1, V2, ....

Insulation Monitoring Device: An insulation monitoring device (not shown) is included in some examples. An example monitor is a Bender Insulation monitoring device.

PDU controller electronics: Each EPDS can include have one or more PDU Controller PCB. The PDU controller in one example is a field programable gate array (FPGA) as a master controller device. Other controller types can be used. An auxiliary power supply board (APS) provides power for FPGA board. The FPGA and APS board in some embodiments have analog circuits to measure different measurement signals.

Wire harness: The PDU controller is connected to variety of sensors, connectors and to other PDU controller with wire harness.

The EPDS (300 in Figure 3) further includes primary batter power inputs 301, 303, 305, 307; secondary battery power inputs 311, 313; HV DC-to-DC outputs 321, 323, and HV ground power interface 341.

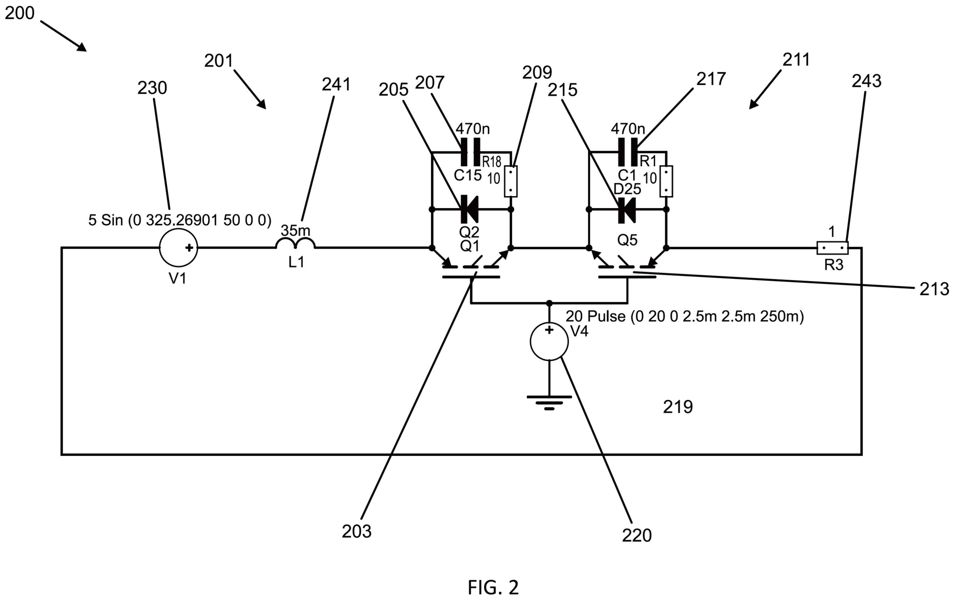

Figure 2 shows a solid-state fuse 200, which includes assemblies 201, 211, each including, respectively, a switching transistor 203, 123, a reverse-biased diode 205, 215, a capacitor 207, 217 and resistor 201, 219. The switching transistors can be, for example, power metal-oxide-semiconductor field-effect transistors (MOSFETs), such as silicon carbide MOSFETs. The MOSFET can be switched on or off by the current source 220, thereby conducting or cutting off current when biased by the voltage 230. An inductor 241 in this example, in combination with other component electronic components, prevent current and voltage spikes.

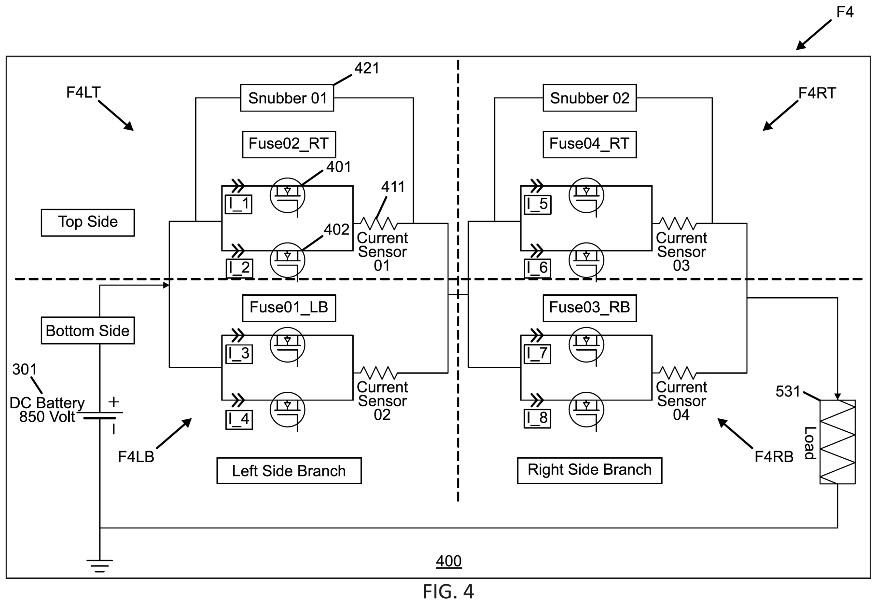

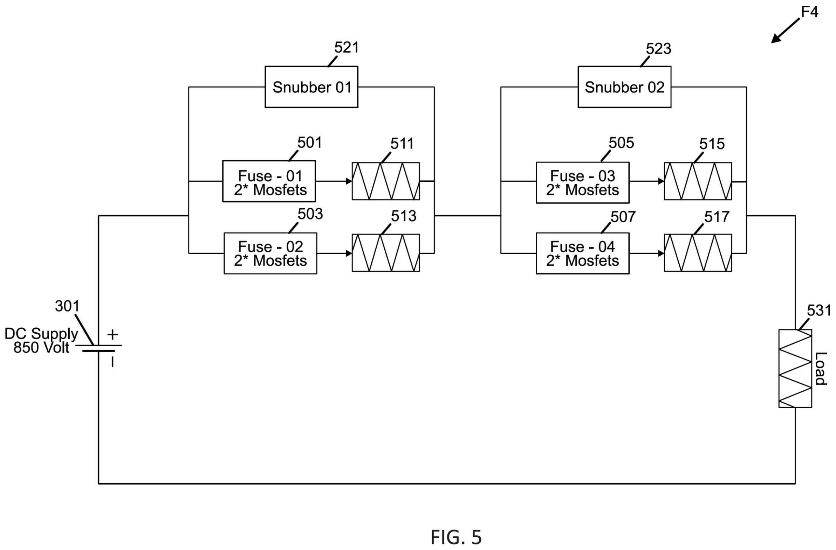

Figure 5 illustrates and example of a solid-state assembly that forms a solid-state fuse, which can be, for example, the fuse F4 in Figure 3. The assembly include four pairs of MOSFETs, where one parallel pair or pairs 501, 503 and the other parallel pair or pairs 505, 507 are connected to each other in series. Each pair 501, etc., of MOSFETS in this example is connected in series with a resistor 511, etc., which acts as a current sensor. Current snubbers 521, 523 are also included as shown. Figure 4 shows a more detailed structure of the assembly F4, showing the parallel MOSFETs 401, 402 in each pair.

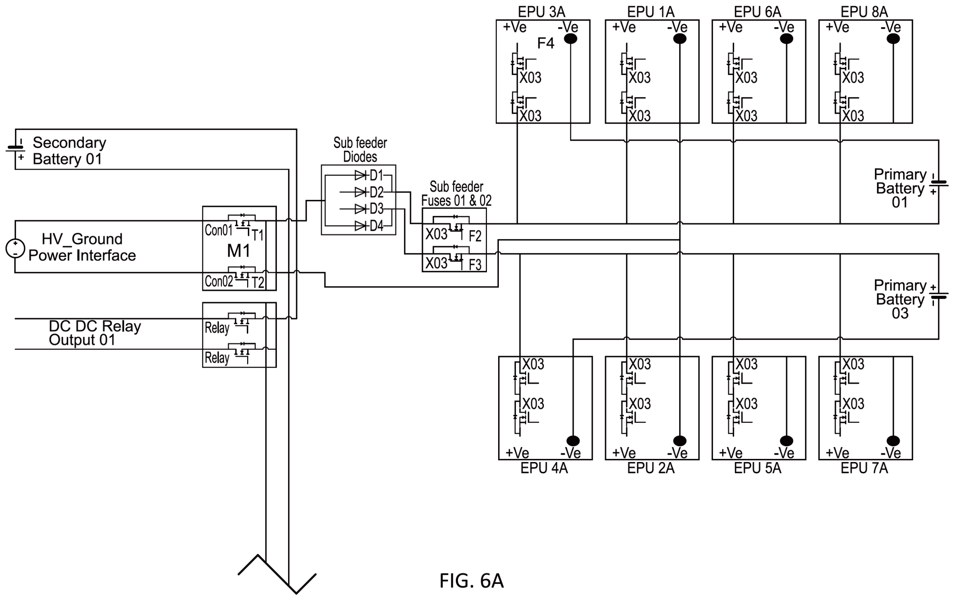

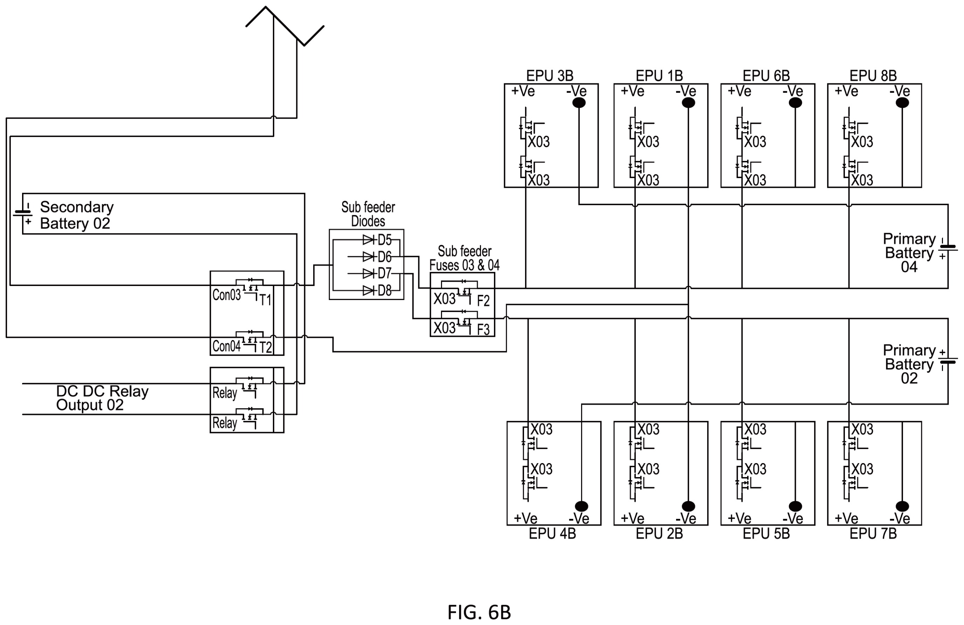

Figure 6 shows a detailed circuit diagram of another implementation of the fuse and switch connections shown in Figure 3. In this example, each fuse F4-F11 and F15-F22 includes serially-connected groups of three MOSFETS in parallel.

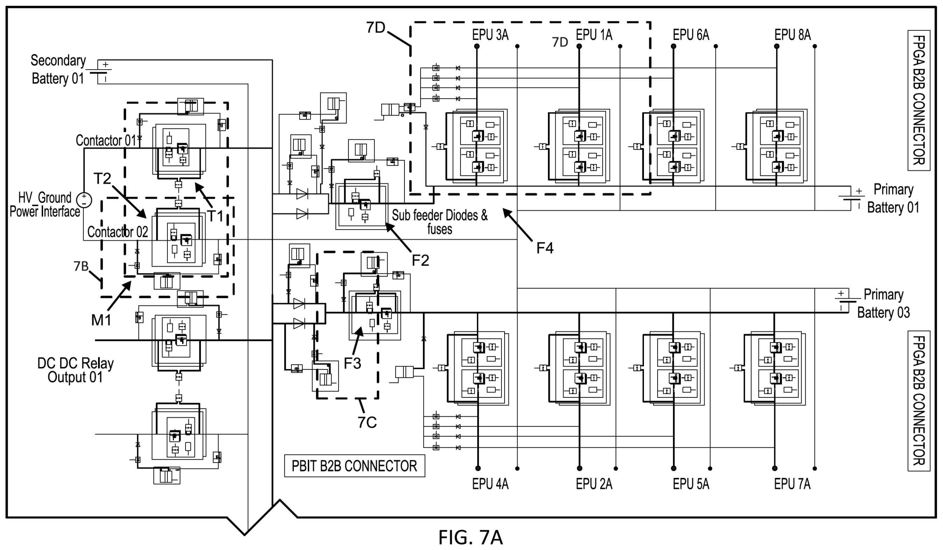

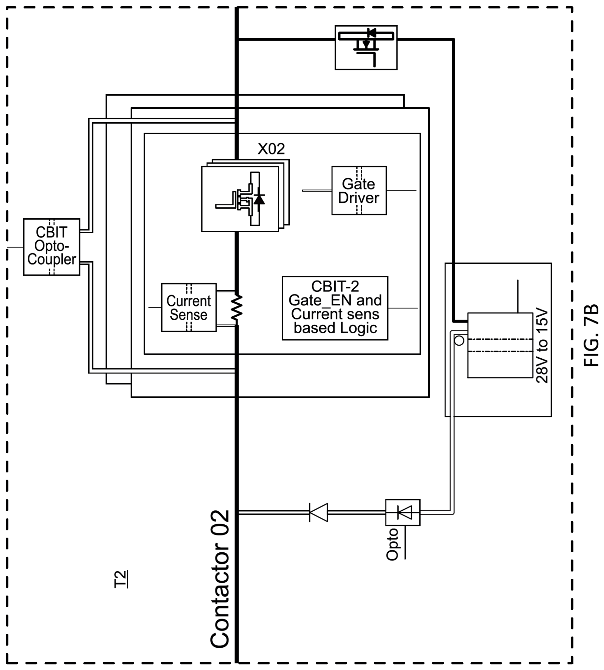

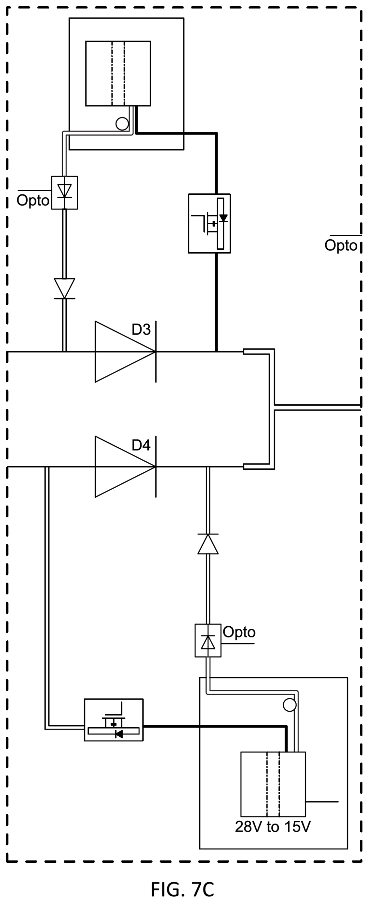

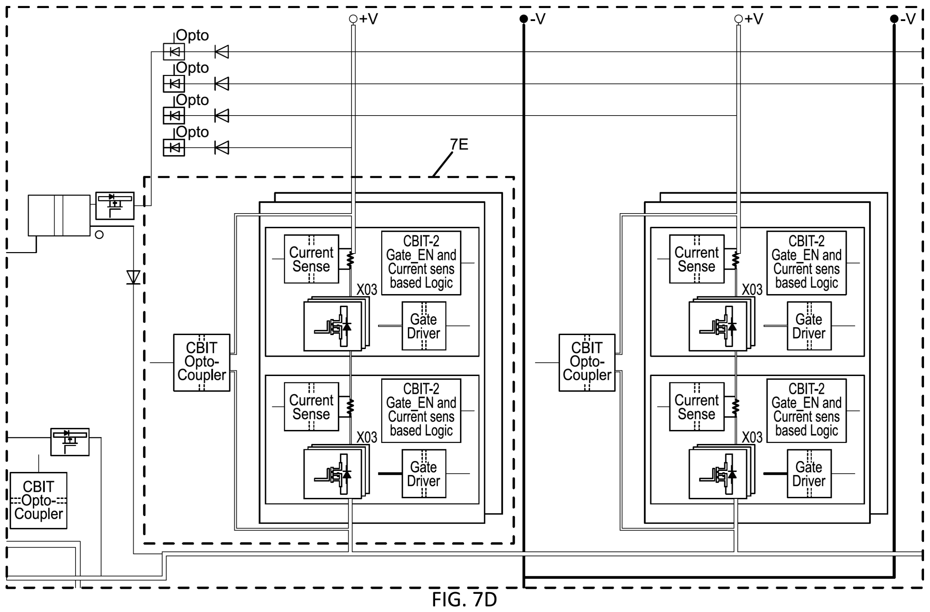

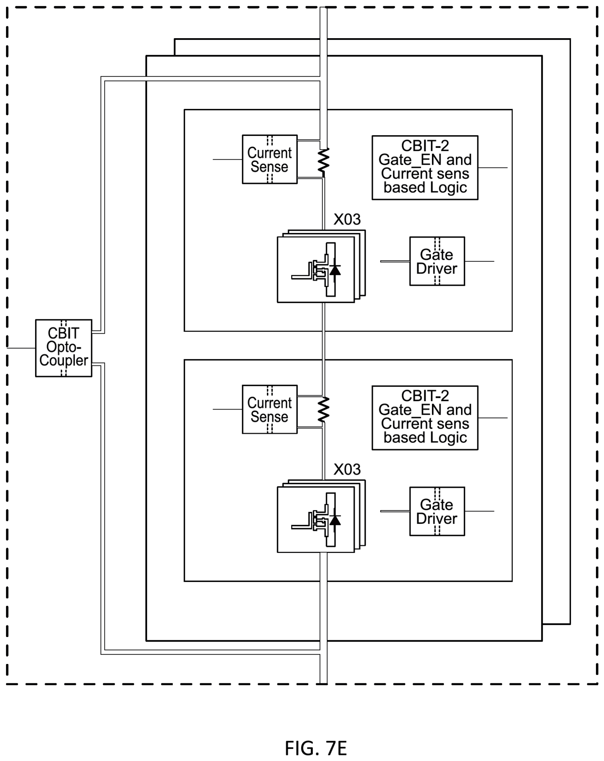

Figure 7A show an embodiment in which each of the fuses, switches and diodes in the type of system in Figure 3 is connected to corresponding PBIT and/or CBIT circuits for monitoring operating conditions to meet the required safely parameters. Figures 7B, 7C, 7D, and 7E show more detailed views of the respective portions of Figure 7A. The various monitoring and control circuits are described in more details below.

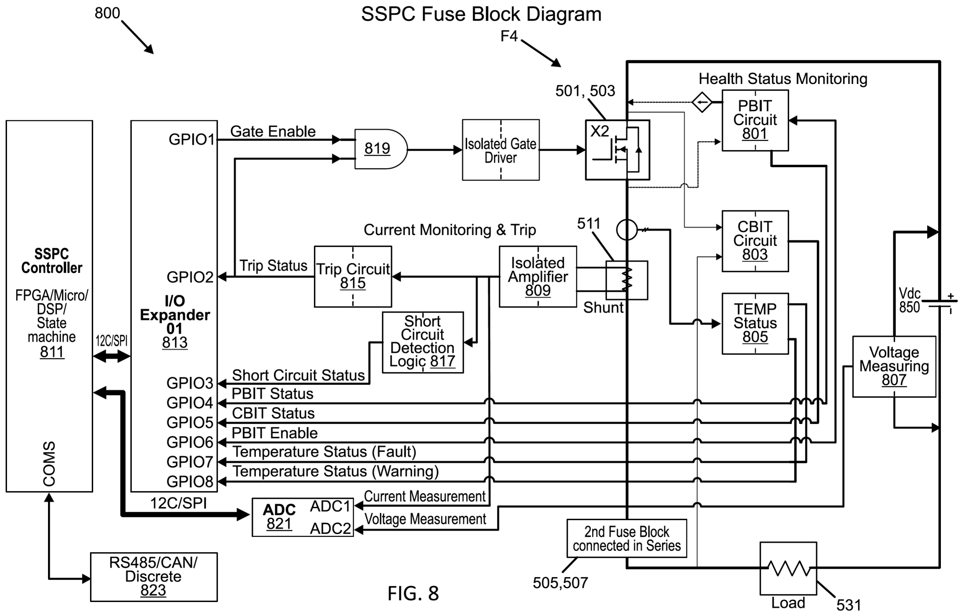

Figure 8 shows a detailed circuit diagram of a fuse, e.g., F4 and the associated monitoring and control devices. The associated circuits include a PBIT circuit 801, CBIT circuit 803, temperature sensor 805, voltage sensor 807, isolated amplifier 809 for amplifying the current signal from the current sensor 511, controller (FPGA in some examples) 811, I/O expander 813, fuse trip circuit 815, short circuit (SC) detector 817, AND gate 819, analog-to-digital converter (ADC) 821 and communication port(s) 823. In this example, the gate of MOSFETS are energizes, and the MOSFETS are thus conducting, only if the current sensed but resistor 511 is sufficiently low and the controller 811 outputs, through the I/O expander 813 a gate enable signal such that the output of the AND gate 819 enables the gate driver to activate the MOSFETS. If the fuse current is too high, the trip circuit 815 will output as trip status signal that will cause the AND gate output to cause the gate driver to turn off the MOSFETs. The processor 811 can also turn off the MOSFET, for example, based on the signal the controller 811 receives from the various sensors 801, 803, 805, 807.

The various components in Figure 8 are described below.

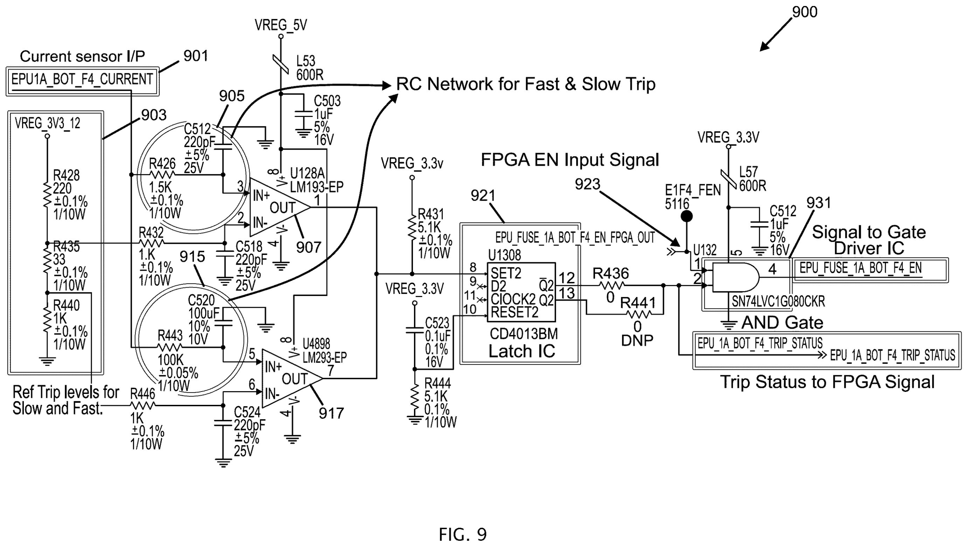

Figure 9 shows an example 900 of the trip circuit 815. The trip circuit includes current sensors 901 (511), fast and slow trip comparators 907, 917 (with reference inputs provided from a reference voltage divider 903), latch IC 921 to lock on to the faults (clears only after power on) and AND gate 931 (819), which allows the FPGA 811 to override the trip block to trip or enable during PBIT when everything is healthy. Each trip block has set trip level for current as per the requirements and upon crossing of that the block trips. The circuit arrangement may, for example, take ~10uS to detect the over current situation and trip. To avoid nuisance tripping, two levels are maintained: slow and fast trip. The Slow trip has a lower current constant and higher time while the fast current trip has higher current trip level and fast time for persistence. The time constants are set by the RC circuits 905 and 915. Trip block is active during normal flight mode of the aircraft when there is actual current flowing. There can be two trip levels slow and fast. When current is in slow trip region usually it is lower current and the moment it crosses high current threshold, it is very quick trip as against the fuse. Arc-free very fast tripping and programable tripping (using R, C values in the circuit) is a significant advantage for solid-state fuses. Especially when the battery/load inductance is very small and a short circuit exists then the current can achieve large amount if the fault is not cleared very fast. This is all done in analog so it is very fast and simple as against digital using microprocessor and ADC network.

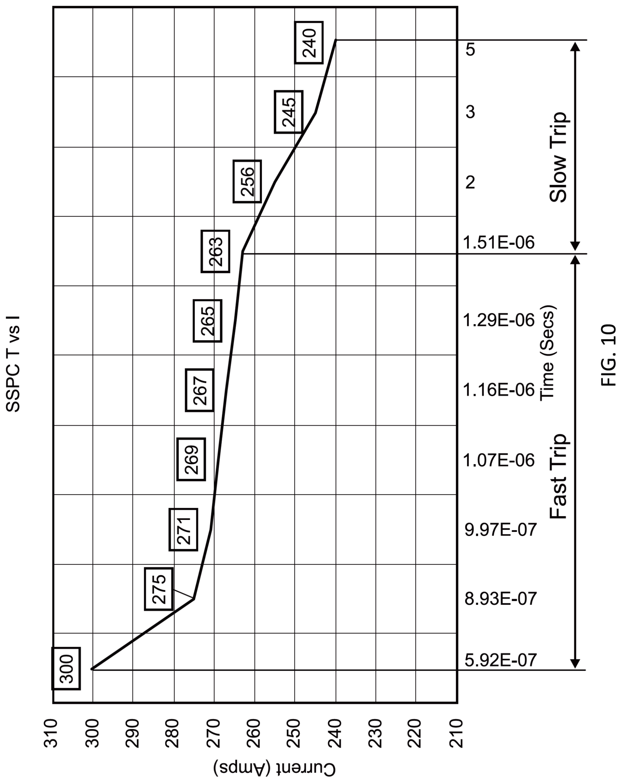

Figure 10 shows and example current-versus-time profile achieved using a circuit of the kind shown in Figure 9. The profile can be set by selecting R, C values for the fast- and slow-trip circuits but can also be done with digital or combination of analog and digital methods.

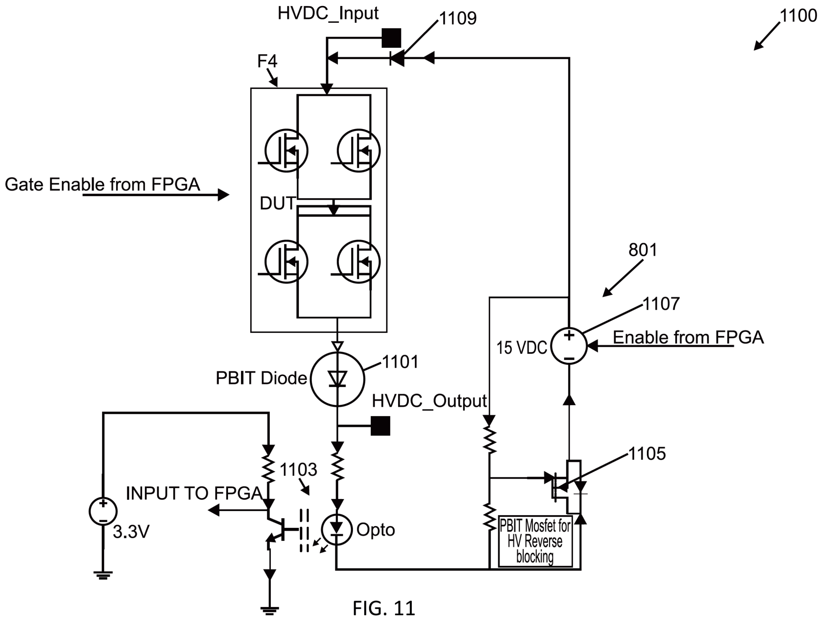

Figure 11 shows a PBIT circuit 1100 (801) for fuses. During PBIT the host processor (DSP/uC/FPGA (811)) ensures there is no HV is presence after that it enables the fuse by turning on the gate of the MOSFETs in the fuse module (e.g., F4), then it enables the PBIT logic which consists of an isolated DC to DC supply 1107 (a MOSFET 1105 can also be included for blocking revers HV). This sends a known amount of current through the MOSFETs. If all the MOSFETs are intact, the current returns and turns on the LED inside an opto coupler 1103, which in turn indicates PBIT has passed. Otherwise a failure condition is indicated. This is repeated for all the fuses.

The following table shows the conditions the Opto-coupler output indicates.

| Enable | | | | Health/Short | | | | Opto O/P |
|---|---|---|---|---|---|---|---|---|
| F1 | F2 | F3 | F4 | F1 | F2 | F3 | F4 | |
| OFF | OFF | OFF | OFF | Short | Short | Short | Short | Low |
| OFF | OFF | OFF | OFF | Healthy | Healthy | Healthy | Healthy | High |
| OFF | OFF | OFF | ON | Healthy | Short | Healthy | Healthy | Low |
| OFF | OFF | OFF | ON | Short | Healthy | Healthy | Healthy | Low |
| ON | OFF | OFF | OFF | Healthy | Healthy | Short | Healthy | Low |
| ON | OFF | OFF | OFF | Healthy | Healthy | Healthy | Short | Low |

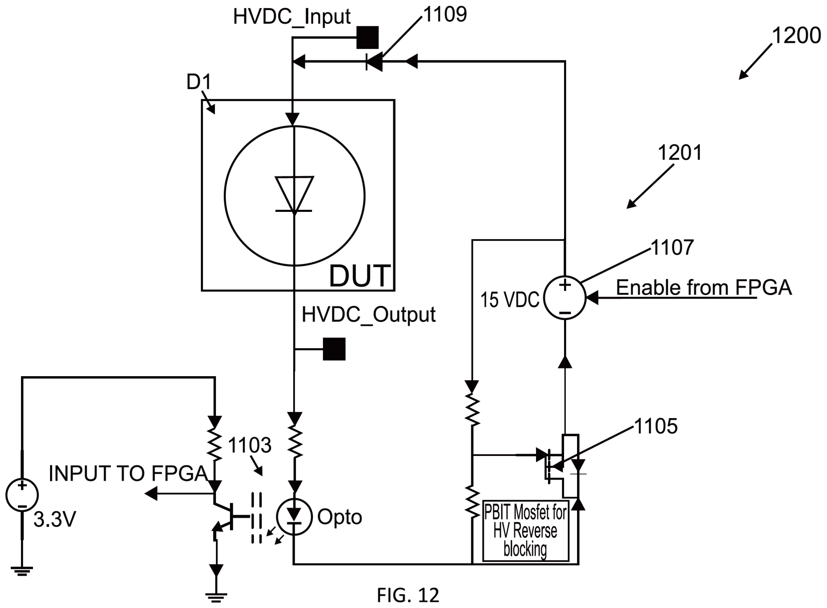

Figure 12 show a PBIT circuit 1200 for a positive-biased diode (e.g., D1). To check the health status of the diode, PBIT circuit is connected across the diode anode and cathode pins. It will detect the health status of diode in a similar way as described above for PBIT of the fuses, when HV is absent.

The following table shows the conditions the Opto-coupler output indicates.

| **Diode Open/Short** | **Opto O/P** |
|---|---|
| Open | High |
| Healthy | Low |

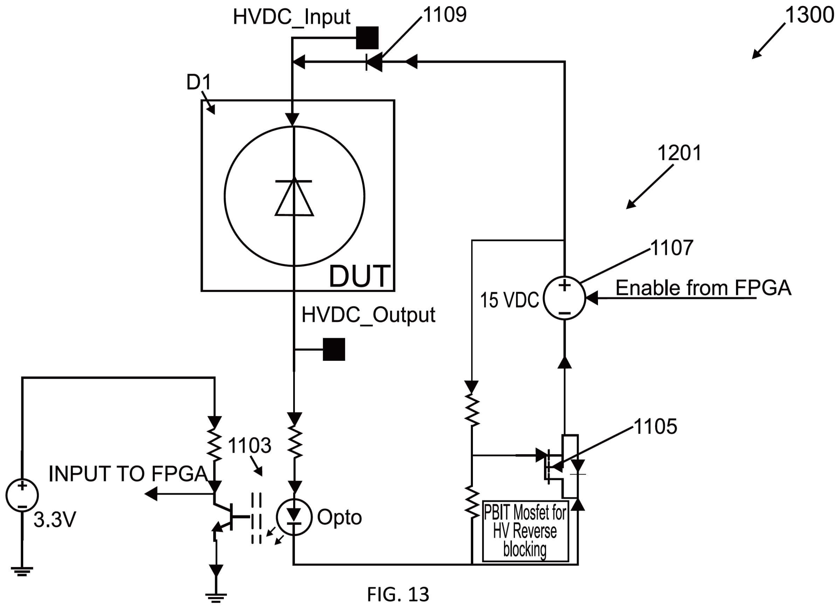

In some embodiments, there are two different power supplies, which will be turned on depending on whether the test is forward or reverse PBIT. Figure 13 show a PBIT circuit 1300 for a reverse-biased diode (e.g., D1). To check the health status of the diode, PBIT circuit is connected across the diode anode and cathode pins. It will detect the health status of diode in a similar way as described above for PBIT of the fuses, when HV is absent.

The following table shows the conditions the Opto-coupler output indicates.

| **Diode Open/Short** | **Opto O/P** |
|---|---|
| Short | Low |
| Healthy | High |

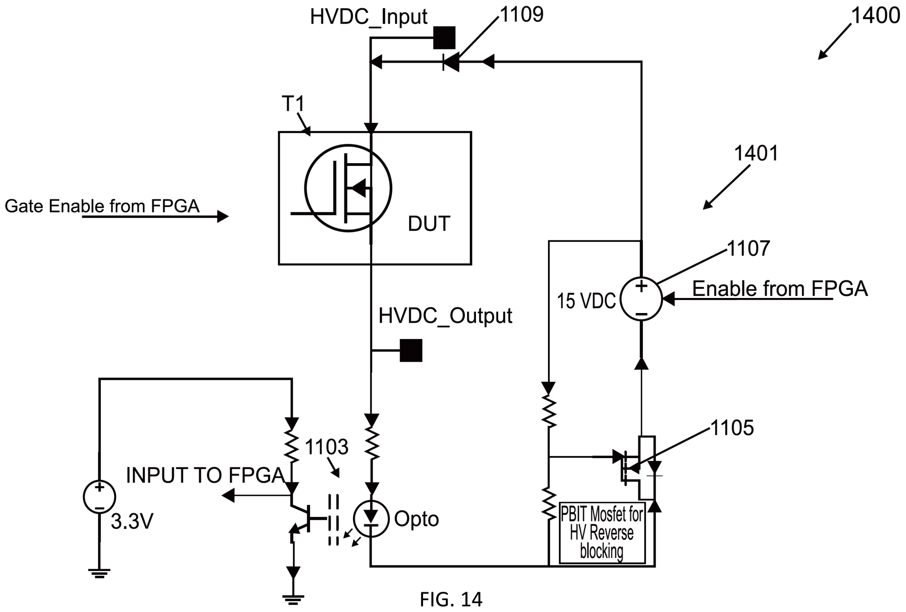

Figure 14 shows a PBIT circuit 1400 for the DC-DC Relay, GPU & Bus tie Contactors and Sub feeder fuses. An isolated LV 15V DC to DC supply 1107 is used supply current through the closed contacts, if the controller has commanded the MOSFET circuit to close then the optocoupler 1103 will be turned ON; else it will be OFF. Even the command is on if the optocoupler is still off then the host controller can detect the open circuit in the PBIT test. Same is repeated for short circuit test, except that in this case the MOSFET circuit will be given no command to turn on.

The following table shows the conditions the Opto-coupler output indicates.

| **Switch S1 Enable** | **Healthy/Short Switch S1** | **Opto O/P** |
|---|---|---|
| OFF | Short | Low |
| OFF | Healthy | High |
| ON | Healthy | Low |
| ON | Open | High |

In addition, in some embodiments, the same PBIT circuit is connected in negative line for Contactor and DC to DC Relay to check health status of MOSFETs. Sub Feeder Fuse is connected only in Positive line.

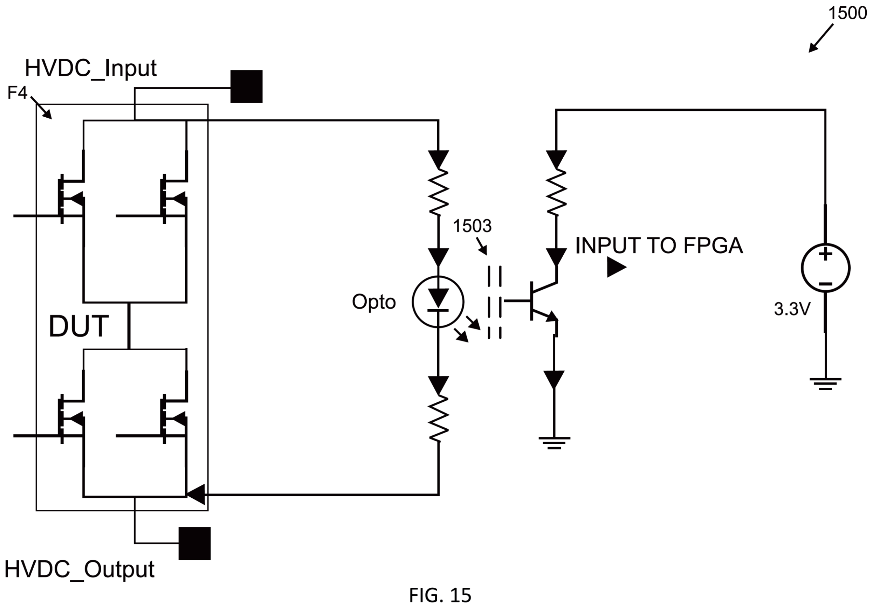

Figure 15 shows a CBIT circuit 1500 (803) for fuses. The controller 811 will do repeated test for CBIT to determine any failures. CBIT is performed to identify the health status of MOSFETs when HV voltage is present. The following are the different types of CBIT's used in SSPC PDU. Two types of CBIT's are used:
- CBIT 01 MOSFET Failed to Open.
   ➢ CBIT 01 for EPU Fuses.
   ➢ CBIT 01 for DC-DC Relay.
   ➢ CBIT 01 for GPU Contactor.
   ➢ CBIT 01 for Sub feeder Fuse.
- CBIT 02 MOSFET Failed to Short.

CBIT 02 logic is the same for EPU Fuse, Contactor, Dc-Dc Relay and Sub feeder fuse.

In CBIT for fuses, every fuse has a Optocoupler in parallel, the moment the fuse opens the current flow through opto and the host controller gets the feedback that fuse is blown. In case short circuit of MOSFET, the host controller 811 expects the device to be open as there is no command, but if it is not it is declared as short circuit. The two fuses in series have a common CBIT section to save components and space.

In the circuit above, when both the MOSFETs in series become open, then only it detects low for the controller to determine there is no connection established to EPUs from the subfeeder. If either of the MOSFETs is conducting, then it is high. For MOSFET itself failing short-circuit, there is another circuit explained later to determine this failure.

The table below explains how along with the MOSFET enable one can determine whether the fuse is open or healthy.

| Enable | | | | Healthy/Open | | | | Opto O/P |
|---|---|---|---|---|---|---|---|---|
| F1 | F2 | F3 | F4 | F1 | F2 | F3 | F4 | |
| ON | ON | ON | ON | Healthy | Healthy | Healthy | Healthy | High |
| ON | ON | ON | ON | Open | Healthy | Healthy | Healthy | High |
| ON | ON | ON | ON | Healthy | Open | Open | Healthy | High |
| ON | ON | ON | ON | Open | Open | Healthy | Healthy | Low |
| ON | ON | ON | ON | Healthy | Healthy | Open | Open | Low |

Feeder FUSE CBIT : Further, if it is feeder fuse and optocoupler software needs to measure the voltage differential across the two batteries and determine if the fuse is open or short along with the enable.

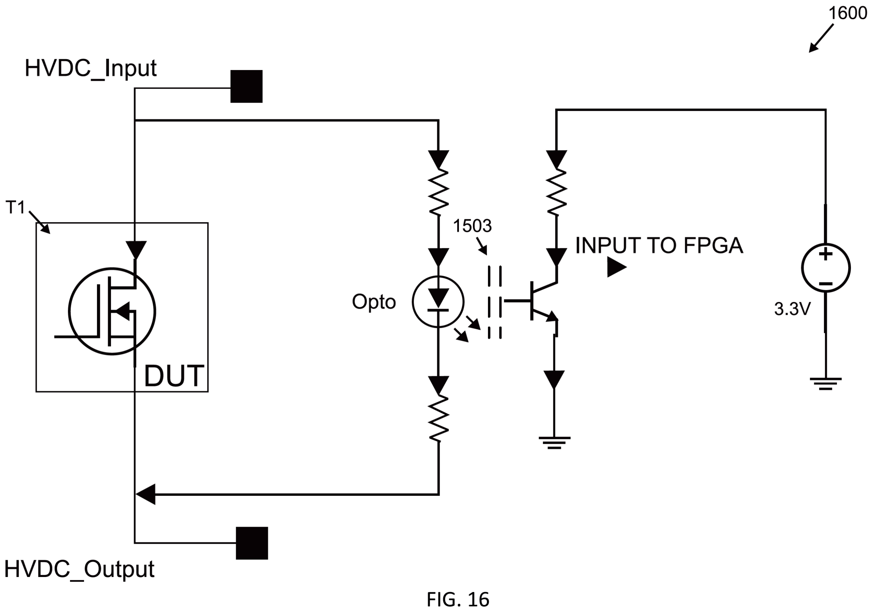

Figure 16 shows a relay CBIT circuit 1600 for the case relay. A single MOSFET in positive line and single MOSFET in negative line

The CBIT conditions indicated are shown as below:

| **Gate Signal** | **Healthy/Open** | **Opto O/P** |
|---|---|---|
| ON | Healthy | High |
| ON | Open | Low |

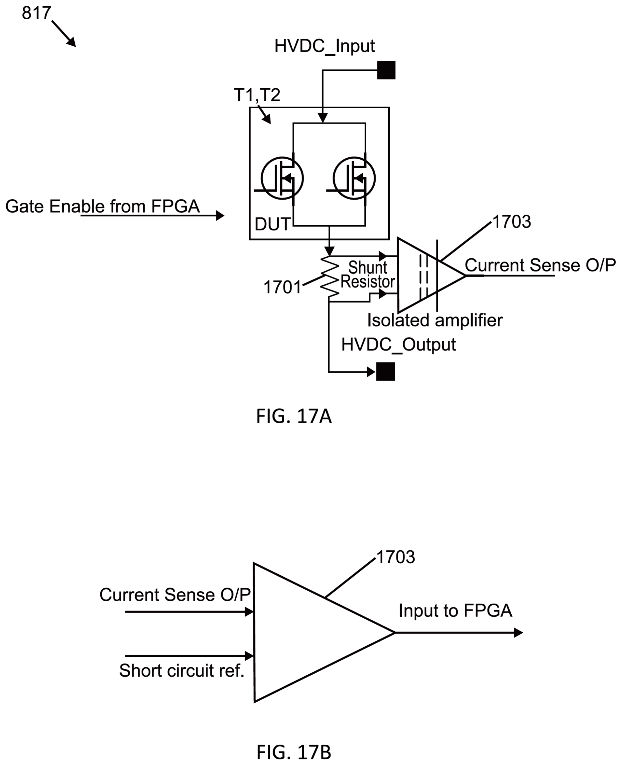

Figure 17 shows a CBIT MOSFET Short Circuit detection circuit 1700. Because SSPC PDU uses many MOSFET a common mode of failure is short circuit, which is detected in CBIT by sensing the current and knowing the state of MOSFET enable. Every MOSFET is accompanied by a current sensor 1701 and comparator 1703. If the MOSFET keep conducting irrespective of the ON command, it is determined as short circuit. The comparator output is fed to the controller like FPGA and it compares it with the MOSFET gate command and decides whether the MOSFET is SC or not. This is particularly useful when fuse is asked to be open and it can't because of short circuit. In this scenario the FPGA 811 uses reductant channel either in negative link or dual channel in series in positive link to open the line.

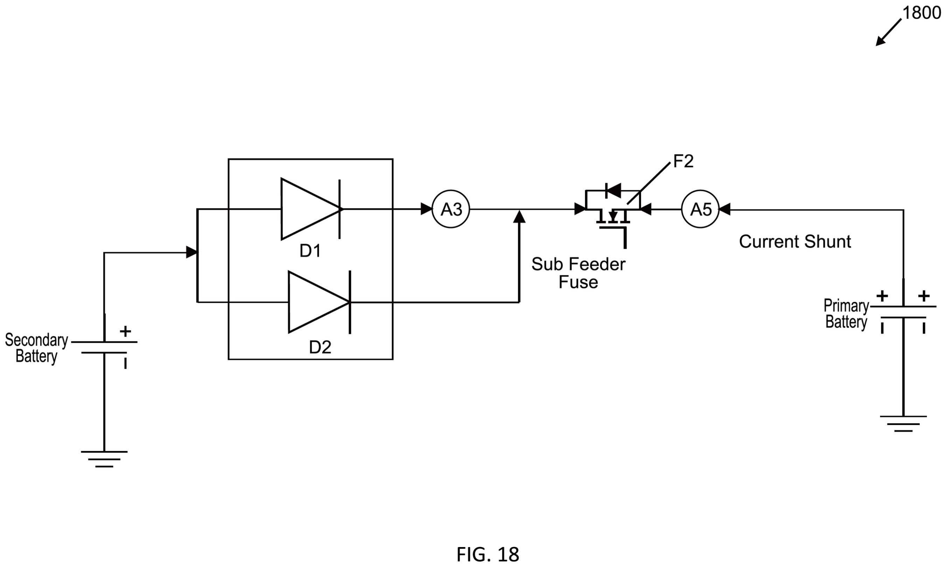

Figure 18 shows a Diode failure detection CBIT circuit 1800. Using the current sensors (e.g., A3 and A5), the controller 811 is monitoring the health of both diodes when HV is present. Diodes in PDU conducts only when primary battery voltage is less than secondary battery. A3 will give the current for a single diode and A5 will give both diode currents from secondary battery.

The table below shows how the controller monitors and declares the health status of both diodes. Same logic is used every branch of Diodes in SSPC PDU.

| **Diode D1** | | **Diode D2** | | **Battery Voltage** | **A3(Current sensor)** | **A5 (Current sensor)** | **Detection Criteria** |
|---|---|---|---|---|---|---|---|
| Healthy | | Healthy | | Primary battery > Secondary battery | 0 | 0 | Healthy condition |
| | | | | Primary battery < Secondary battery | A3 = A5/2 | A5 = 2^{•}A3 | |
| | | | | Primary battety = Secondary battery | A3 = A5/2 | A5 = 2^{•}A3 | |
| Healthy | | Unhealthy | Open | Primaiy battery > Secondary battery | 0 | 0 | Detected only in PBIT |
| | | | | Primary battery < Secondary battery | A3 = A5 | A5 = A3 | A3 = A5 |
| | | | | Primary battery = Secondary battery | A3 = A5 | A5 = A3 | A3 = A5 |
| | | | Short | Primary battery > Secondary battery | 0 | A5 is negative | A5 = negative |
| | | | | Primary battery < Secondary battery | A3=0 | A5= positive | A3 = 0 & A5 = positive |
| | | | | Primary battery = Secondary battery | A3=0 | A5 = A7 | A3 = 0 & A5 = positive |
| Unhealthy | Open | Healthy | | Primary battery > Secondary battery | 0 | 0 | Detected only in PBIT |
| | | | | Primary battery < Secondary battery | 0 | A5 = Positive | A3=0 & A5 = positive |
| | | | | Primary battery = Secondary battery | 0 | A5 = A7 | A3=0 & A5 = positive |
| | Short | | | Primary battery > Secondary battery | A3 = A5 | A5 = A3 | A5 = negative or A3=A5 |
| | | | | Primary battery < Secondary battery | A3 =A5 | A5 = A3 | A3 = A5 |
| | | | | Primary battery= Secondary battery | A3 = A5 | A5 = A3 | A3= A5 |
| Unhealty | Open | Unhealthy Unhealthy | Open | Primary battery > Secondary battery | 0 | 0 | Detected only in PBIT |
| | | | | Primary battery < Secondary battery | 0 | 0 | A3= 0 & A5=0 & V2>V3 |
| | | | | Primary battery = Secondary battery | 0 | 0 | A3= 0 & A5=0 & V2>V3 |
| | Open | | Short | Primary battery > Secondary battery | 0 | A5= Negative | A5 = negative |
| | | | | Primary battery < Secondary battery | 0 | A5 = positive | A3=0 & A5 = positive |
| | | | | Primary battery = Secondary battery | 0 | A5 = A7 | A3=0 & A5 = positive |
| | Short | | Open | Primary battery > Secondary battery | A3 = A5 | A5 = A3 | A3 =A5 = negative |
| | | | | Primary battery < Secondary battery | A3 = A5 | A5 = A3 | A3 = A5 |
| | | | | Primary battery = Secondary battery | A3 = A5 | A5 = A3 | A3 = A5 |
| | Short | | Short | Primary battery > Secondary battery | A3 = A5 & A3 = AS/2 | A5 = A3 or A5 = 2*A3 | A3 or A5 is negative |
| | | | | Primary battery < Secondary battery | A3 = A5 & A3 = AS/2 | A5 = A3 or A5 = 2*A3 | Detected only in PBIT |
| | | | | Primary battery= Secondary battery | A3 = A5 & A3 = AS/2 | A5 = A3 or A5 = 2*A3 | Detected only in PBIT |

Although various examples and examples are described herein, those of ordinary skill in the art will understand that many modifications may be made thereto within the scope of the present disclosure. Accordingly, it is not intended that the scope of the disclosure in any way be limited by the examples provided.

## Claims

1. A power distribution device, comprising:
one or more input terminals, each being connectable to a respective electrical power supply;
one or more output terminals, each being connectable to one or more electric devices; and
one or more electrical paths, each connecting a respective one of the one or more input terminals and a respective one of the one or more output terminals and comprising one or more solid-state fuses.

2. The power distribution device of claim 1, wherein each of the one or more solid-state fuses comprises a plurality of switching transistors.

3. The power distribution device of claim 2, wherein each of the plurality of switching transistors comprises a silicon-carbide (SiC) metal-oxide-semiconductor field-effect transistor (MOSFET).

4. The power distribution device of claim 1, further comprising:
one or more built-in test (BIT) circuits adapted to monitor an operating condition of the one or more solid-state fuses and generate an output signal indicative of the operating condition; and
a controller having an input adapted to receive the output signal from the one or more BIT circuits and being adapted to set a state of current flow in the conductive path based on the signal received from the one or more BIT circuits

5. The power distribution device of claim 4, wherein each of the one or more BIT circuits comprises continuous BIT (CBIT) circuit.

6. The power distribution device of claim 5, wherein each of the one or more BIT circuits comprises power-on BIT (PBIT) circuit.

7. The power distribution device of claim 1, wherein at least one of the one or more electrical paths further comprises a diode adapted to limit electrical current flow in the electrical path to one direction along the conductive path.

8. The power distribution device of claim 1, wherein the one or more solid-state fuses comprise a plurality of redundant solid-state fuses.

9. The power distribution device of claim 4, wherein the one or more BIT circuits comprise a plurality of redundant BIT circuits.

10. An aircraft propulsion system, comprising:
one or more electrical power supplies;
one or more electrical propulsion devices; and
a power distribution device, comprising:
one or more input terminals, each being connectable to a respective one of the one or more electrical power supplies;
one or more output terminals, each being connectable to the one or more electrical propulsion devices; and
one or more electrical paths, each connecting a respective one of the one or more
input terminals and a respective one of the one or more output terminals and comprising one or more solid-state fuses.

11. The aircraft propulsion system of claim 10, wherein each of the one or more solid-state fuses comprises a plurality of switching transistors.

12. The aircraft propulsion system of claim 11, wherein each of the plurality of switching transistors comprises a silicon-carbide (SiC) metal-oxide-semiconductor field-effect transistor (MOSFET).

13. The aircraft propulsion system of claim 10, further comprising:
one or more built-in test (BIT) circuits adapted to monitor an operating condition of the one or more solid-state fuses and generate an output signal indicative of the operating condition; and
a controller having an input adapted to receive the output signal from the one or more BIT circuits and being adapted to set a direction of current flow in the conductive path based on the signal received from the one or more BIT circuits and to change the current flow following a predetermined time profile.

14. The aircraft propulsion system of claim 10, wherein at least one of the one or more electrical paths further comprises a diode adapted to limit electrical current flow in the electrical path to one direction along the conductive path.

15. The aircraft propulsion system of claim 10, wherein the one or more solid-state fuses comprise a plurality of redundant solid-state fuses.
